# FASCICULE DE BREVET EUROPEEN

(11) **EP 0 750 313 B1**
(45) Date de publication et mention de la délivrance du brevet: **30.09.1998**
(21) Numéro de dépôt: 96470012.4
(22) Date de dépôt: 17.06.1996
(51) Int. Cl.: G11C 16/04, G11C 16/06

(54) **Mémoire EEPROM programmable et effaçable par effet de Fowler-Nordheim**
EEPROM-Speicher, der mit Fowler-Nordheim Effekt programmiert und gelöscht wird
EEPROM memory, programmed and erased by Fowler-Nordheim effect

(30) Priorité: 21.06.1995 FR 9507622
(43) Date de publication de la demande: 27.12.1996
(73) Titulaire: SGS-THOMSON MICROELECTRONICS S.A., 94250 Gentilly (FR)
(72) Inventeur: Guedj, Marc, Cabinet Ballot Schmit, 57000 Metz (FR); Brigati, Allessandro, Cabinet Ballot Schmit, 57000 Metz (FR); Aulas, Maxence, Cabinet Ballot Schmit, 57000 Metz (FR); Demange, Nicole, Cabinet Ballot Schmit, 57000 Metz (FR)
(74) Mandataire: Schmit, Christian Norbert Marie

(56) Documents cités:
- EP-A- 0 332 274
- EP-A- 0 637 035

## Description

L'invention concerne les mémoires mortes électriquement programmables et effaçables, dites EEPROM. Plus particulièrement, elle concerne une architecture de mémoire EEPROM programmable et effaçable par effet de Fowler-Nordheim.

Les cellules de mémorisation des mémoires EEPROM sont généralement formées d'un transistor de mémorisation à grille flottante et d'un transistor de sélection permettant de relier le transistor de mémorisation à une ligne de mot et une ligne de bit. Les mémoires EEPROM utilisent le principe du stockage non volatil de charges sur la grille flottante du transistor à grille flottante. Classiquement, l'écriture (on parlera dans la suite du document de programmation) se fait par injection par effet tunnel d'électrons du drain ou de la source vers la grille flottante (ou de la grille flottante vers le drain ou la source), et l'effacement se fait par injection par effet tunnel d'électrons de la grille flottante vers le drain ou la source (ou du drain ou de la source vers la grille flottante). On connaît également des mémoires EEPROM dites flash. Dans ces mémoires il n'y a pas de transistor de sélection, et les transistors de mémorisation sont directement reliés aux lignes de mot et de bit. On procède dans ce cas à un effacement global des cellules de mémorisation. Ce type de mémoire permet de diminuer la taille de la mémoire à capacité de mémorisation équivalente.

L'injection d'électrons du drain (ou de la source) vers la grille de commande d'un transistor de mémorisation se fait classiquement par mise à la masse du drain (ou de la source) de ce transistor, application d'une tension positive relativement élevée sur sa grille de commande (de l'ordre de + 15 volts) pour créer un champ attractif, et application d'une tension positive modérée (+ 6 à + 9 volts) sur la source (ou le drain) pour générer des électrons chauds. Quand un nombre suffisamment important de charges négatives s'est accumulé sur la grille flottante le potentiel de la grille flottante atteint le potentiel de seuil du transistor et empêche le passage de courant dans un mode de lecture.

L'injection d'électrons de la grille flottante vers le drain (ou la source) se fait par application d'une tension positive relativement élevée (+ 15 volts) sur le drain (ou la source), la grille de commande des transistors de mémorisation étant mise à la masse, et la source (ou le drain) étant flottant. Les charges négatives sont alors extraites de la grille flottante et dirigées vers le drain (ou la source) par effet Fowler-Nordheim. L'épaisseur de l'oxyde entre la grille flottante et le drain (ou la source) doit être suffisamment faible (de l'ordre de 100 x 10⁻¹⁰ m ou moins) pour permettre l'injection par effet Fowler-Nordheim.

Ce type de mémoire présente des inconvénients, notamment dans la mise en oeuvre de l'éjection des électrons des grilles flottantes :
- le courant drain-substrat (ou source-substrat) pendant l'éjection est relativement important et impose en pratique, pour des mémoires de grandes capacités, de disposer d'une source de tension positive élevée qui soit externe au circuit,
- une tension inverse relativement importante est générée entre le drains (ou les sources) et le substrat pendant l'éjection. En pratique cela impose d'utiliser des drains (ou sources) à double diffusion, ce qui diminue la densité d'implantation des cellules,
- l'application d'une tension positive relativement élevée durant l'effacement sur les drains (ou les sources) augmente la probabilité de création de trous chauds, par effet d'avalanche à la surface de la jonction drain-substrat (ou source-substrat), ceux-ci étant piégés dans l'oxyde mince situé sous la grille flottante.

Pour plus de précisions sur ces phénomènes, on se reportera au brevet US-5 077 691 de Advanced Micro Devices Inc.

Dans ce document il est proposé d'effacer les cellules par application d'une tension négative relativement élevée (- 12 à - 17 volts) sur les grilles de commande, une tension positive relativement faible (+ 0.5 à + 5 volts) étant imposée sur les sources, le substrat étant relié à la masse, et les drains étant laissés en haute impédance. Ainsi, on peut induire un effet Fowler-Nordheim tout en gardant une tension inverse source-substrat inférieur à + 5 volts. Le courant de fuite de la source vers le substrat est réduit, permettant d'alimenter la mémoire avec une seule source de tension positive externe (+ 5 volts). D'autre part cela permet d'utiliser des sources comprenant une seule diffusion, ce qui limite la surface des cellules. Enfin, on peut éliminer la création de trous chauds, ce qui augmente la fiabilité de la mémoire.

Une autre réalisation de mémoire EEPROM est dévoilée dans EP-A-0 332 274.

Un but de l'invention est de proposer une mémoire EEPROM ayant un fonctionnement de même type que celui décrit ci-dessus et une structure telle que l'effacement des cellules de mémorisation soit opérée sélectivement par groupes de bits.

Ainsi, l'invention propose une mémoire EEPROM organisée matriciellement en N lignes de mot et M lignes de bit, N et M étant des nombres entiers, comprenant
des cellules de mémorisation placées aux intersections des lignes de mots et des lignes de bits, ces cellules de mémorisation comprenant des transistors de mémorisation à grille flottante de type N pour mémoriser des états électriques, les cellules de mémorisation étant regroupées en groupes de K cellules, K nombre entier, les cellules d'un même groupe étant reliées à une même ligne de mot et à K lignes de bit distinctes,
des premières lignes de sélection et des lignes de commande, associées aux groupes de cellules, pour véhiculer des potentiels de sélection et de commande,
un premier transistor de sélection de groupe de type P par groupe de cellule pour relier, via son canal, les grilles flottantes des transistors de mémorisation d'un même groupe de cellules à une des lignes de commande, la grille de commande du premier transistor de sélection étant reliée à une des premières ligne de sélection, lors de la programmation, de l'effacement, ou de la lecture du contenu des cellules du groupe de cellules auquel est associé le premier transistor de sélection de groupe.

Dans une version préférée, la mémoire comprend des deuxièmes lignes de sélection associées au groupes de cellules et au moins une ligne de référence pour véhiculer des potentiels de sélection et de référence, et un deuxième transistor de sélection de groupe de type P par groupe de cellule pour relier, via son canal, les grilles flottantes des transistors de mémorisation d'un même groupe de cellules à la ligne de référence, la grille de commande du deuxième transistor de sélection étant reliée à une des deuxièmes ligne de sélection, de telle manière que les potentiels des grilles de commande des transistors de mémorisation des cellules du groupe associé soient dans un état non flottant quand ces grilles de commande sont isolées de la ligne de commande associée au groupe.

D'autres particularités et avantages apparaîtront à la lecture de la description ci-après d'exemples de mise en oeuvre de l'invention, à lire conjointement aux dessins annexés dans lesquels :
- la figure 1 représente schématiquement un premier exemple de mise en oeuvre de l'invention,
- la figure 2 représente schématiquement un deuxième exemple de mise en oeuvre de l'invention
- la figure 3 représente schématiquement un troisième exemple de mise en oeuvre de l'invention
- la figure 4 représente schématiquement un quatrième exemple de mise en oeuvre de l'invention

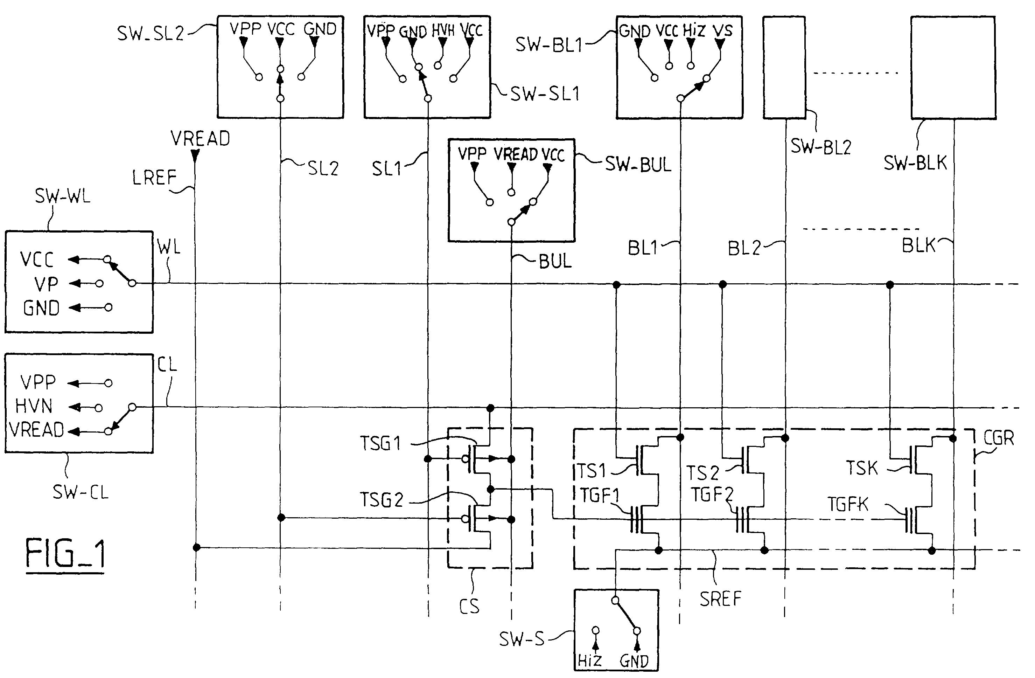

La figure 1 présente schématiquement un premier exemple de mise en oeuvre de l'invention.

Cette figure représente une partie d'une mémoire EEPROM effaçable par groupes de K cellules de mémorisation, K nombre entier, et réalisée selon l'invention. Typiquement, K sera égal à huit.

On suppose que cette mémoire est organisée matriciellement en N lignes de mot WL et M lignes de bit BL, N et M étant des nombres entiers.

Cette mémoire comprend des cellules de mémorisation placées aux intersections des lignes de mots et des lignes de bits, chacune des cellules étant dans un état électrique représentatif d'un état logique binaire. Les cellules d'un même groupe sont reliées à une même ligne de mot et à K lignes de bit distinctes.

Sur la figure 1, on a représenté une ligne de mot WL et un groupe CGR de cellules de mémorisation reliées à cette ligne de mot. Chacune des K cellules (non toutes représentées) est respectivement reliée à une ligne de bit parmi K lignes de bit, portant les références BL1 à BLK. On comprendra bien sûr qu'une mémoire réalisée conformément à l'invention pourra contenir un nombre de plusieurs dizaines ou plusieurs centaines de milliers de cellules de mémorisation.

Les K cellules du groupe de cellules CGR comprennent chacune un transistor de sélection, référencés respectivement TS1 à TSK, et un transistor de mémorisation à grille flottante, référencés respectivement TGF1 à TGFK. Dans l'exemple décrit, on supposera que la mémoire est réalisée de manière classique, en technologie MOS, à partir d'un substrat de type P. Les transistors de sélection et de mémorisation sont des transistors de type N. Les transistors de sélection TS1 à TSK ont leur drain relié respectivement aux lignes de bit BL1 à BLK. Leur grilles de commande sont reliées à la ligne de mot WL. Enfin, chacun des transistors de sélection TS1 à TSK a sa source reliée respectivement au drain des transistors TGF1 à TGFK. Les transistors de sélection permettent de relier ou d'isoler les drains des transistors TGF1 à TGFK des lignes de bit BL1 à BLK.

Les grilles de commande des transistors à grille flottante du groupe CGR sont reliées entre elles et à un circuit de sélection de groupe CS dont la composition est décrite ci-après.

On supposera que les sources des transistors à grille flottante TGF1 à TGFK des cellules de mémorisation de la mémoire sont toutes reliées à une ligne de source commune SREF.

Le circuit de sélection CS comprend un premier et un deuxième transistor dits de sélection de groupe, référencés respectivement TSG1 et TSG2. Ce sont deux transistors de type P. Leurs drains sont reliés entre eux et aux grilles de commande des transistors TGF1 à TGFK.

Le premier transistor de sélection de groupe TSG1 a sa source reliée à une ligne dite de commande, référencée CL. Sa grille de commande est reliée à une première ligne dite de sélection, référencée SL1.

Le deuxième transistor de sélection de groupe TSG2 a sa source reliée à une ligne dite de référence, référencée LREF. Sa grille de commande est reliée à une deuxième ligne dite de sélection, référencée SL2.

Les deux transistors de sélection de groupe TSG1 et TSG2 ont leurs caissons reliés à une ligne de caisson commune, référencée BUL. On supposera que tous les caissons des transistors de sélection de groupe associés aux groupe de cellules de la mémoire sont reliés à cette ligne BUL, chaque groupe ayant un circuit de sélection associé comprenant deux transistors de sélection de groupe.

Les lignes CL, LREF, SL1 et SL2 sont des lignes conductrices permettant de porter les grilles de commande des transistors de mémorisation TGF1 à TGFK à différents potentiels, selon que l'on sélectionne ou non les cellules comprenant ces transistors, pour lire, programmer ou effacer leur contenu.

La mémoire comprend :
- un circuit SW-S de commutation de source relié à la ligne de source commune SREF, permettant de commander le potentiel de cette ligne de source,
- N circuits SW-WL de commutation de ligne de mot, reliés chacun à une des N lignes de mot WL, pour commander les potentiels des lignes de mot,
- M circuits SW-BL de commutation de ligne de bit, reliés chacun à une des M lignes de bit BL, pour commander les potentiels des lignes de bit,
- des premiers et deuxièmes circuits SW-SL1 et SW-SL2 de commutation de ligne de sélection, reliés respectivement aux premières et deuxièmes lignes de sélection, pour commander les potentiels de ces lignes,
- un circuit SW-BUL de commutation de caisson, relié à la ligne de caisson commune BUL pour commander le potentiel de cette ligne.

Comme on l'a dit, le contenu des cellules se détermine au travers des caractéristiques électriques des transistors à grille flottante. Plus précisément, on qualifiera le contenu des cellules par rapport à la présence ou l'absence d'électrons au niveau des grilles flottantes. Dans un mode de lecture d'une cellule, on imposera une tension positive de lecture sur le drain de son transistor à grille flottante, le transistor de sélection de la cellule étant passant, et la source du transistor à grille flottante étant reliée à la masse. Selon la présence d'électrons ou non sur la grille flottante du transistor de mémorisation, sa grille de commande étant polarisée positivement de manière adéquate, le courant parcourant le canal de ce transistor sera plus ou moins important. Par comparaison de ce courant, qui parcourt la ligne de bit associée, avec un courant de référence on déterminera l'état électrique de la cellule et donc son contenu informationnel.

Dans l'exemple décrit on considérera par exemple que la présence d'électrons représente un état effacé et que l'absence d'électrons représente un état programmé. On pourrait tout aussi bien convenir de la convention inverse. On ne décrira pas ici les dispositifs (amplificateurs de lecture, décodeurs de lignes de mot et de ligne de bit, etc) qui constituent classiquement une mémoire, l'invention se rapportant spécifiquement à l'architecture du plan mémoire.

On distinguera trois types d'opération sur les cellules.

Dans un premier mode, dit de programmation, on injectera des électrons des grilles flottantes des transistors de mémorisation vers leurs drains.

Dans un deuxième mode, dit d'effacement, on injectera des électrons des drains des transistors de mémorisation vers leurs grilles flottantes.

Dans un troisième mode, dit de lecture, on polarisera les transistors de mémorisation de manière à les rendre passants, la valeur du courant parcourant leur canal dépendant de l'état électrique de leur grille flottante.

Dans ces différents modes les lignes de sélection SL1 et SL2, de commande CL, de référence LREF, de source commune SREF, de caisson commun BUL, de mot WL et de bit BL seront portées à différents potentiels.

Dans l'exemple illustré on utilise les potentiels suivants :
- un potentiel de masse GND = 0 V et un potentiel d'alimentation VCC = + 5 V (fournis par l'extérieur),
- un potentiel d'effacement VPP = + 15 V,
- un potentiel de programmation HVN = - 8 V,
- un potentiel de commande de programmation HVH = - 10V,
- un potentiel de sélection de ligne de mot en programmation VP = + 7 V,
- un potentiel de sélection de ligne de bit en lecture VS = + 2 V,
- un potentiel de commande de lecture VREAD = + 2.3 V.

On notera HiZ un état de haute impédance.

Typiquement les potentiels GND et VCC sont disponibles sur des broches de connexion de la mémoire. Les autres potentiels seront de préférence produits de manière interne à la mémoire, ce qui permet de limiter le nombre de broches de connexion de la mémoire. Les potentiels de valeur absolue plus grande que celle de VCC seront produits typiquement à partir de circuits élévateurs de tension, appelés communément pompes de charge, dont la réalisation est bien connue de l'homme du métier.

Le circuit SW-S de commutation de source permet de porter le potentiel de la ligne de source commune SREF au potentiel de masse GND ou de mettre cette ligne en état de haute impédance.

Les N circuits SW-WL de commutation de ligne de mot permettent de porter le potentiel des lignes de mot WL à l'un des potentiels VCC, VP ou GND.

Les M circuit SW-BL de commutation de ligne de bit permettent de porter le potentiel des lignes de bit BL à l'un des potentiels VCC, VS ou GND, ou de mettre ces lignes en état de haute impédance.

Les premiers circuits SW-SL1 de commutation de ligne de sélection permettent de porter le potentiel des premières lignes de sélection SL1 à l'un des potentiels VCC, VPP, HVH ou GND.

Les deuxièmes circuits SW-SL2 de commutation de ligne de sélection permettent de porter le potentiel des deuxièmes lignes de sélection SL2 à l'un des potentiels VCC, VPP, ou GND.

Le circuit SW-BUL de commutation de caisson permet de porter le potentiel de la ligne commune de caisson BUL à l'un des potentiels VCC, VPP, ou VREAD.

Enfin la ligne de référence LREF est maintenue au potentiel VREAD.

On ne décrira pas en détail ces circuits de commutation dont la réalisation ne posera pas de problème à l'homme de métier.

La mémoire comprend N lignes de commande, de telle sorte que tous les groupes de cellules reliés à une même ligne de mot WL ont leurs premiers transistors de sélection de groupe TSG1 reliés à une même ligne de commande CL.

Avantageusement, on commandera les circuits de commutation SW-CL et SW-SL1 de telle manière qu'un seul groupe de cellules reliées à une même ligne de mot WL soit relié simultanément à la ligne de commande CL associée à cette ligne de mot. En procédant ainsi, on limite à K le nombre de grilles de commande de transistors à grille flottante reliées simultanément à une ligne de commande CL. De ce fait on limitera la capacité équivalente induite vue par cette ligne CL. On limitera donc le temps de montée au potentiel de cette ligne des grilles de commandes reliées à ladite ligne.

Les groupes de cellules dont les cellules sont reliées à K mêmes lignes de bit ont leur premier transistor de sélection TSG1 reliés à une même première ligne de sélection SL1. De ce fait, on aura une première ligne de sélection SL1 pour K lignes de bit, ce qui limite l'encombrement de la mémoire.

De même, dans un souci de compacité, les groupes de cellules dont les cellules sont reliées à K mêmes lignes de bit auront avantageusement leur deuxième transistor de sélection de groupe TSG2 reliés à une même deuxième ligne de sélection SL2. On aura ainsi une deuxième ligne de sélection SL2 pour K lignes de bit.

Les groupes de cellules dont les cellules sont reliées à K mêmes lignes de bit ont leur deuxième transistor de sélection de groupe TSG2 reliés à une même ligne de référence LREF. Ainsi, on prévoit une ligne de référence LREF pour K lignes de bit, ce qui limite l'encombrement de la mémoire. On notera que l'on pourra relier entre elles les lignes de référence courant parallèlement aux lignes de bit, ce qui reviendra à avoir une seule ligne de référence. En effet, ces lignes de référence sont constamment portées au même potentiel VREAD.

Les lignes de référence LREF sont utilisée de telle manière que les potentiels des grilles de commande des transistors à grille flottante des cellules de groupe soient dans un état non flottant quand ces grilles de commande sont isolées des lignes de commande CL. On évite ainsi une perturbation des états électriques des transistors de mémorisation, qui pourraient être modifiés par couplage capacitif. Cela amènerait des variations des caractéristiques qui pourraient être plus ou moins importantes selon les cellules, ce qui n'est pas souhaitable. En effet, le comportement des cellules en mode de lecture serait variable, ce qui induirait des variations de temps de réaction, voire des incertitudes sur le contenu informationnel des cellules.

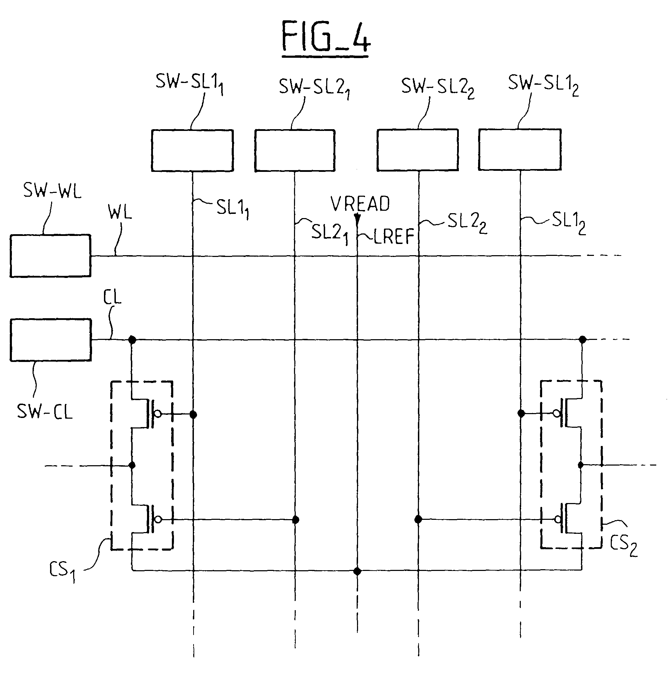

Avantageusement, les lignes de bit étant regroupées en ensembles de K lignes, on regroupera ces ensemble deux par deux de telle sorte que les groupes de cellules dont les cellules sont reliées à l'un ou l'autre de deux ensembles de K lignes de bit regroupées ont leur deuxième transistor de sélection de groupe TSG2 reliés à une même ligne de référence LREF. Ainsi, on divise par deux l'encombrement du aux lignes de référence. Ceci est illustré figure 4 qui montre deux circuits de sélection CS₁ et CS₂ reliés à une même ligne de commande CL. Les circuits CS₁ et CS₂ sont reliés respectivement à des premières lignes de sélection SL1₁ et SL1₂, à des deuxièmes lignes de sélection SL2₁ et SL2₂, et à une ligne de référence LREF placée entre les circuits CS₁ et CS₂.

On peut également disposer les lignes de référence parallèlement aux lignes de mot et de commande. Cet exemple est illustré figure 3. Les groupes de cellules reliés à une même ligne de mot ont alors leurs deuxièmes transistors de sélection de groupe reliés à une même ligne de référence. Dans ce cas, on regroupera de même avantageusement les lignes de mot deux par deux, et les groupes de cellules reliés à l'une ou l'autre de deux lignes de mot regroupées auront leur deuxième transistor de sélection de groupe reliés à une même ligne de référence, dans un souci de compacité de la mémoire. Ainsi, la figure 3 montre deux circuits de sélection CS₁ et CS₂ reliés respectivement à des lignes de commande CL₁ et CL₂, à des lignes de mot WL₁ et WL₂, et à une ligne de référence commune LREF.

Le choix de positionner les lignes de référence parallèlement aux lignes de bit ou aux lignes de mot dépendra du nombre de lignes de bit et de lignes de mot, de la surface et de la forme envisageables de la mémoire.

En pratique, les lignes de bit seront réalisées sur une première couche de métallisation. Les lignes de sélection s'étendant parallèlement aux lignes de bit, il en sera de même pour celles-ci si on souhaite limiter le nombre de couches de métallisations.

Les lignes de commande seront réalisées sur une deuxième couche de métallisation. En effet, comme elles s'étendent parallèlement aux lignes de mot, il est nécessaire de les réaliser sur une couche de métallisation différente pour éviter de court-circuiter les lignes entres elles. Dans la mesure où on dispose de deux couches de métallisation, on aura intérêt à réaliser les lignes de mot sur la deuxième couche de métallisation plutôt qu'une couche de polysilicium. En effet, la résistivité est très inférieure pour une ligne en métal, ce qui limite l'échauffement et le temps de stabilisation à un potentiel désiré.

Quand aux lignes de référence, selon l'option choisie, elles seront réalisées sur la première ou la deuxième couche de métallisation.

Bien que l'on parle de première et de deuxième couche de métallisation, on pourra réaliser physiquement celles ci respectivement au dessus ou au dessous l'une de l'autre.

On va maintenant aborder le fonctionnement de la mémoire, et plus particulièrement les potentiels présents sur les différentes lignes conductrices en fonction du mode de fonctionnement choisi.

### 1 - Mode de programmation.

Si on souhaite programmer une ou des cellules d'un groupe CGR, c'est à dire injecter des électrons des grilles flottantes de leurs transistors de mémorisation vers leurs drains, on commandera les circuits de commutation de sorte que :
- la ligne de source commune est mise en état de haute impédance et la ligne de caisson commune est portée au potentiel VREAD.
- on porte la ou les lignes de bit BL1 à BLK, reliées à la ou les cellules concernées, au potentiel VCC.
- on porte la ligne de mot WL à laquelle le groupe est relié à un potentiel supérieur au potentiel VCC, par exemple au potentiel VP. Ainsi, les transistors de sélection associés aux cellules à programmer sont passants et le drain des transistors de mémorisation de ces cellules est au potentiel VCC.
- on porte la ligne de commande CL au potentiel HVN.
- on porte la première ligne de sélection à un potentiel inférieur au potentiel HVN, par exemple au potentiel HVH, de telle sorte que le premier transistor de sélection de groupe soit passant. Les grilles de commande des transistors de mémorisation du groupe concerné par la programmation sont ainsi portées au potentiel HVN.
- on porte la seconde ligne de sélection à un potentiel supérieur au potentiel VREAD, par exemple au potentiel VCC, de telle sorte que le deuxième transistor de sélection de groupe soit bloqué.

On va ainsi créer un champ répulsif de l'ordre de - 13 V entre les grilles flottantes et les drains des transistors à programmer. On notera que l'on aurait aussi bien pu choisir de produire un potentiel HVN = - 15 V et de porter les lignes de bit au potentiel GND. On préférera la solution retenue qui, en limitant la valeur absolue du potentiel négatif produit, réduit le nombre d'étages de pompage nécessaire pour le produire à partir de VCC.

Pour les groupes de cellules reliés à K lignes de bit distinctes de celles auxquelles sont reliées la ou les cellules à programmer, on porte :
- la première ligne de sélection à un potentiel supérieur à HVN, par exemple au potentiel VCC, de telle sorte qu'aucun des premiers transistors de sélection de groupe ne soit passant, et
- la seconde ligne de sélection à un potentiel inférieur au potentiel VREAD, par exemple au potentiel GND, de telle sorte que les deuxièmes transistors de sélection soient passants (les grilles de commande des transistors à grille flottante reçoivent donc le potentiel VREAD présent sur les lignes de référence).

Pour les groupes de cellules reliées à des lignes de mot distinctes de celle à laquelle sont reliées la ou les cellules à programmer, on porte :
- les lignes de commande correspondantes CL au potentiel VREAD, et
- les lignes de mot correspondantes au potentiel GND.

Ainsi, pour une cellule d'un groupe programmée on impose VCC sur le drain du transistor de sélection, VP sur la grille de commande du transistor de sélection (afin de le rendre passant), et HVN sur la grille de commande du transistor de mémorisation (afin d'injecter des électrons de sa grille flottante vers son drain).

Pour une cellule d'un groupe différent relié à la même ligne de mot, on impose GND (ou un état de haute impédance) sur le drain du transistor de sélection, VP sur la grille de commande du transistor de sélection, et VREAD sur la grille de commande du transistor de mémorisation, de telle sorte qu'il n'y a pas injection d'électrons de la grille flottante vers le drain.

Pour une cellule d'un groupe différent relié à la même ligne de bit, on impose VCC sur le drain du transistor de sélection, GND sur la grille de commande du transistor de sélection (de telle sorte qu'il soit bloqué), et VREAD sur la grille de commande du transistor de mémorisation.

Pour une cellule d'un groupe relié à des lignes de mot et de bit différentes, on impose GND (ou un état de haute impédance) sur le drain du transistor de sélection, GND sur la grille de commande du transistor de sélection, et VREAD sur la grille de commande du transistor de mémorisation.

### 2 - Mode d'effacement.

Si on souhaite effacer les cellules d'un groupe CGR, c'est à dire injecter des électrons des drains de leurs transistors de mémorisation vers leurs grilles flottantes, on commandera les circuits de commutation de sorte que :
- la ligne de source commune est portée au potentiel GND et la ligne de caisson commune est portée au potentiel VPP.
- on porte la ligne de mot WL à laquelle le groupe est relié au potentiel VCC.
- on porte toutes les lignes de bit de la mémoire au potentiel GND (on pourra aussi les laisser flottantes). Les transistors de sélection associés aux cellules à effacer sont donc passants.
- on porte la ligne de commande CL au potentiel VPP.
- on porte la première ligne de sélection du groupe à effacer à un potentiel inférieur au potentiel VPP, par exemple au potentiel GND. Le premier transistor de sélection de groupe est donc passant, et les grilles de commande des transistors de mémorisation du groupe CGR sont portées au potentiel VPP. On crée ainsi un champ attractif de l'ordre de + 15 V entre les grilles flottantes et les drains des transistors à effacer.
- on porte la seconde ligne de sélection à un potentiel supérieur au potentiel VREAD, par exemple au potentiel VPP, de telle façon que le deuxième transistor de sélection de groupe soit bloqué.

Pour les groupes de cellules reliés à K lignes de bit distinctes de celles auxquelles sont reliées les cellules à effacer, on porte :
- la première ligne de sélection au potentiel VPP, et
- la seconde ligne de sélection à un potentiel inférieur au potentiel VREAD, par exemple au potentiel GND, de telle sorte que le deuxième transistor de sélection de groupe soit passant (les grilles de commande des transistors à grille flottante reçoivent donc le potentiel VREAD).

Pour les groupes de cellules reliées à des lignes de mot distinctes de celle à laquelle sont reliées les cellules à effacer, on porte :
- les lignes de commande correspondantes au potentiel VREAD, et
- les lignes de mot correspondantes au potentiel GND.

Ainsi, pour une cellule d'un groupe effacé on impose GND sur le drain du transistor de sélection, VCC sur la grille de commande du transistor de sélection (afin de le rendre passant), et VPP sur la grille de commande du transistor de mémorisation, afin de produire un champ attractif.

Pour une cellule d'un groupe différent relié à la même ligne de mot, on impose GND sur le drain du transistor de sélection, VCC sur la grille de commande du transistor de sélection, et VREAD sur la grille de commande du transistor de mémorisation, de telle sorte que la différence de potentiel grille flottante - drain soit insuffisante pour effacer le contenu du transistor de mémorisation.

Pour une cellule d'un groupe différent relié à la même ligne de bit, on impose GND sur le drain du transistor de sélection, GND sur la grille de commande du transistor de sélection, et VREAD sur la grille de commande du transistor de mémorisation.

Pour une cellule d'un groupe différent reliée à des lignes de mot et de bit différentes, on impose GND sur le drain du transistor de sélection, GND sur la grille de commande du transistor de sélection, et VREAD sur la grille de commande du transistor de mémorisation.

### 3 - Mode de lecture.

Si on souhaite lire une cellule de mémorisation d'un groupe CGR, on commandera les circuits de commutation de telle sorte que :
- la ligne de source commune est portée au potentiel GND et la ligne de caisson commune est portée au potentiel VCC.
- on porte toutes les lignes de commande CL au potentiel VREAD.
- on porte la ligne de mot WL à laquelle la cellule à lire est reliée à un potentiel supérieur au potentiel VS, par exemple au potentiel VCC, de telle sorte que le transistor de sélection de la cellule à lire est passant.
- on porte la ligne de bit à laquelle la cellule est reliée au potentiel VS. On laisse les autres lignes de bit dans un état de haute impédance.
- on porte la première ligne de sélection à un potentiel inférieur au potentiel VREAD, par exemple au potentiel GND, de telle sorte que le premier transistor de sélection de groupe du groupe de la cellule à lire soit passant.
- on porte la seconde ligne de sélection à un potentiel supérieur au potentiel VREAD, par exemple au potentiel VCC, de telle sorte que le deuxième transistor de sélection de groupe du groupe de la cellule à lire soit bloqué, ce qui permet d'isoler la ligne de commande correspondante de la ligne de référence.

Pour un groupe de cellules relié à K lignes de bit distinctes et à la même ligne de mot que celles auxquelles est reliée la cellule à lire, on porte :
- la première ligne de sélection à un potentiel supérieur au potentiel VREAD, par exemple au potentiel VCC, de telle sorte que le premier transistor de sélection de groupe soit bloqué, et
- la seconde ligne de sélection à un potentiel inférieur au potentiel VREAD, par exemple au potentiel GND, de telle sorte que le deuxième transistor de sélection de groupe soit passant (les grilles de commande des transistors à grille flottante du groupe reçoivent donc le potentiel VREAD).

Pour un groupe de cellules reliées à une ligne de mot distincte de celle à laquelle est reliée la cellule à lire, on porte les lignes de mot correspondantes au potentiel GND.

Ainsi, pour une cellule à lire on impose VS sur le drain du transistor de sélection, VCC sur la grille de commande du transistor de sélection (de telle sorte qu'il soit passant), et VREAD sur la grille de commande du transistor de mémorisation, de telle sorte qu'il soit passant également.

Pour une autre cellule reliée à la même ligne de mot, on impose un état de haute impédance sur le drain du transistor de sélection, VCC sur la grille de commande du transistor de sélection, et VREAD sur la grille de commande du transistor de mémorisation.

Pour une cellule d'un groupe différent relié à la même ligne de bit, on impose VS sur le drain du transistor de sélection, GND sur la grille de commande du transistor de sélection (de telle sorte qu'il soit bloqué), et VREAD sur la grille de commande du transistor de mémorisation.

Pour une cellule d'un groupe différent relié à des lignes de mot et de bit différentes, on impose un état de haute impédance sur le drain du transistor de sélection, GND sur la grille de commande du transistor de sélection, et VREAD sur la grille de commande du transistor de mémorisation.

Par souci de concision, on ne détaillera pas les circuits de commande des circuits de commutation. Typiquement, ces circuits seront des circuits logiques combinatoires produisant des signaux de commande en fonction du mode choisi, de la ligne de mot sélectionnée et de la ou des lignes de bit sélectionnées. Le fonctionnement de la mémoire (et plus particulièrement la position des circuits de commutation en fonction du mode choisi) ayant été décrit ci-dessus, l'homme du métier n'aura aucune difficulté particulière à les réaliser.

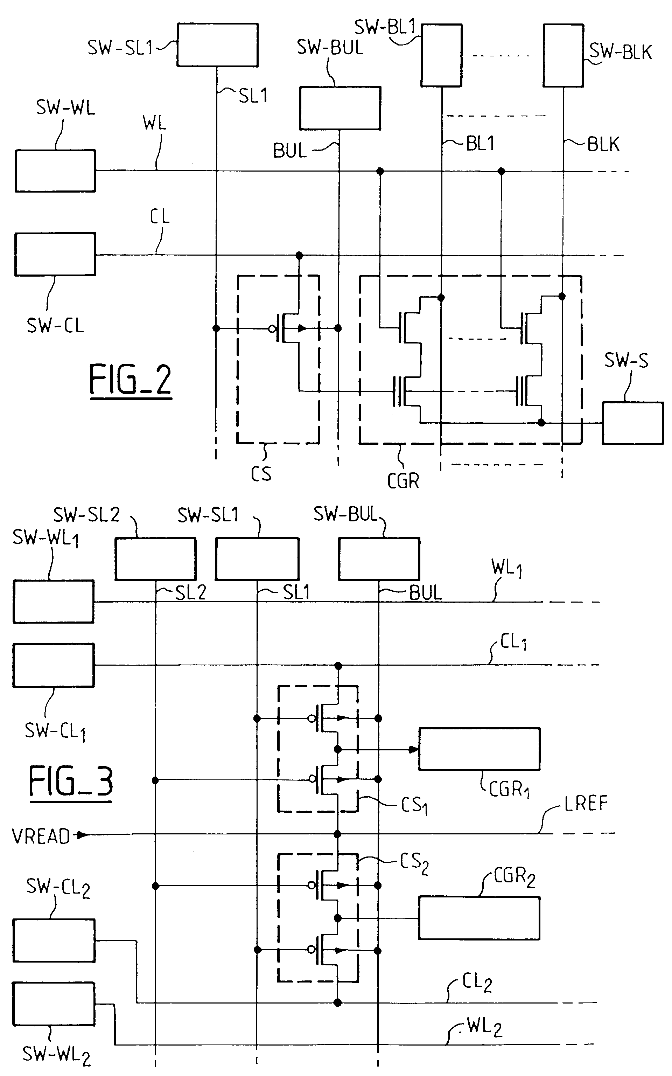

Bien que la description fasse référence à une deuxième ligne de sélection et à une ligne de référence, on comprendra que leur présence n'est pas en toute rigueur nécessaire pour programmer, effacer ou lire les cellules de mémorisation. Leur fonction, comme il a été écrit, est uniquement d'assurer en toute circonstance la présence d'un potentiel défini au niveau des grilles de commande des transistors de mémorisation. On pourra, si l'on accepte que ces grilles de commande puissent être laissées dans un état flottant, utiliser des circuits de sélection ne comprenant qu'un seul transistor, et supprimer les deuxième lignes de sélection et les lignes de référence. Ce cas, qui permet de diminuer l'encombrement de la mémoire, est illustré figure 2.

## Revendications

1. Mémoire EEPROM (1) programmable et effaçable par effet de Fowler-Nordheim, organisée matriciellement en N lignes de mot (WL) et M lignes de bit (BL), N et M étant des nombres entiers, et comprenant
des cellules de mémorisation placées aux intersections des lignes de mot (WL) et des lignes de bit (BL) ces cellules de mémorisation comprenant des transistors de mémorisation à grille flottante (TGF1,...,TGFK) de type N pour mémoriser des états électriques, les cellules de mémorisation étant regroupées en groupes (CGR) de K cellules, K nombre entier, les cellules d'un même groupe étant reliées à une même ligne de mot et à K lignes de bit distinctes,
des premières lignes de sélection (SL1) et des lignes de commande (CL), associées aux groupes de cellules, pour véhiculer des potentiels de sélection (VPP, VCC, HVH, GND) et de commande de programmation, d'effacement ou de lecture (VPP, HVN, VREAD),
un premier transistor de sélection de groupe de type P (TSG1) par groupe de cellules pour relier, via son canal, les grilles flottantes des transistors de mémorisation d'un même groupe de cellules à une des lignes de commande, la grille de commande du premier transistor de sélection étant reliée à une des premières ligne de sélection, lors de la programmation, de l'effacement ou de la lecture du contenu des cellules du groupe de cellules auquel est associé le premier transistor de sélection de groupe.

2. Mémoire selon la revendication 1, caractérisée en ce qu'elle comprend N lignes de commande de telle sorte que tous les groupes de cellules reliés à une même ligne de mot ont leurs premiers transistors de sélection de groupe reliés à une même ligne de commande.

3. Mémoire selon la revendication 2, caractérisée en ce que la mémoire comprend des moyens de commutation (SW-CL, SW-SL1) pour porter à différents potentiels de sélection et de commande les premières lignes de sélection et de commande, de telle manière qu'un seul groupe de cellules reliées à une même ligne de mot est relié simultanément à la ligne de commande associée à cette ligne de mot.

4. Mémoire selon l'une des revendications 2 à 3, caractérisée en ce que les groupes de cellules dont les cellules sont reliées à K mêmes lignes de bit ont leur premier transistor de sélection reliés à une même première ligne de sélection.

5. Mémoire selon l'un des revendications 1 à 4, caractérisée en ce qu'elle comprend
des deuxièmes lignes de sélection (SL2) associées au groupes de cellules et au moins une ligne de référence (LREF) pour véhiculer des potentiels de sélection (VPP, VCC, HVH, GND) et de référence (VPP, HVN, VREAD), et
un deuxième transistor de sélection de groupe de type P (TSG2) par groupe de cellule (CGR) pour relier, via son canal, les grilles flottantes des transistors de mémorisation (TGF1,...,TGFK) d'un même groupe de cellules à la ligne de référence (LREF), la grille de commande du deuxième transistor de sélection (TSG2) étant reliée à une des deuxièmes ligne de sélection (SL2), de telle manière que les potentiels des grilles de commande des transistors de mémorisation des cellules du groupe associé soient dans un état non flottant quand ces grilles de commande sont isolées de la ligne de commande (CL) associée au groupe.

6. Mémoire selon la revendication 5, caractérisée en ce que les groupes de cellules dont les cellules sont reliées à K mêmes lignes de bit ont leur deuxième transistor de sélection reliés à une même ligne de référence.

7. Mémoire selon la revendication 6, caractérisée en ce que les lignes de bit sont regroupées en ensembles de K lignes, ces ensembles de K lignes étant regroupés deux par deux , et en ce que les groupes de cellules dont les cellules sont reliées à l'un de deux ensembles de K lignes de bit regroupés ont leur deuxième transistor de sélection de groupe reliés à une même ligne de référence.

8. Mémoire selon l'une des revendications 5 à 7, caractérisée en ce que les groupes de cellules dont les cellules sont reliées à K mêmes lignes de bit ont leur deuxième transistor de sélection de groupe reliés à une même deuxième ligne de sélection (SL2).

9. Mémoire selon la revendication 5, caractérisée en ce que les groupes de cellules reliés à une même ligne de mot (WL₁, WL₂) ont leur deuxième transistor de sélection de groupe reliés à une même ligne de référence (LREF).

10. Mémoire selon la revendication 9, caractérisée en ce que les lignes de mot sont regroupées deux par deux, et en ce que les groupes de cellules reliés à l'une ou l'autre de deux lignes de mot (WL₁, WL₂) regroupées ont leur deuxième transistor de sélection de groupe reliés à une même ligne de référence (LREF).

11. Mémoire selon l'une des revendications 1 à 10, caractérisée en ce que les lignes de bit (BL1,..., BLK) et les lignes de sélection (SL1, SL2) sont réalisées sur une même première couche de métallisation, et en ce que les lignes de commande (CL) sont réalisées sur une deuxième couche de métallisation.

12. Mémoire selon l'une des revendications 5 à 10, caractérisée en ce que les lignes de bit (BL1,...,BLK), les lignes de sélection (SL1, SL2) et les lignes de référence (LREF) sont réalisées sur une même première couche de métallisation, et en ce que les lignes de commande (CL) sont réalisées sur une deuxième couche de métallisation.

13. Mémoire selon l'une des revendications 11 ou 12, caractérisée en ce que les lignes de mot (WL) sont réalisées sur la deuxième couche de métallisation.

## Patentansprüche

1. EEPROM-Speicher (1), der mittels Fowler-Nordheim-Effekt programmierbar und löschbar ist und matrixförmig aufgeteilt ist in N-Wortleitungen (WL) und M-Bitleitungen (BL), wobei N und M ganze Zahlen sind, und der umfaßt:
Speicherzellen, die an den Schnittpunkten der Wortleitungen (WL) und Bitleitungen (BL) angeordnet sind, wobei diese Speicherzellen Speichertransistoren mit schwimmendem Gate (TGF1, ..., TGFK) vom N-Typ zum Speichern elektrischer Zustände umfassen, wobei die Speicherzellen in Gruppen (CGR) von K-Zellen zusammengefaßt sind, wobei K eine ganze Zahl ist, wobei die Zellen einer gleichen Gruppe mit einer gleichen Wortleitung von K unterschiedlichen Bitleitungen verbunden sind,
erste Auswahlleitungen (SL1) und Steuerleitungen (CL), die zu den Zellengruppen gehören, um Potentiale zum Auswählen (VPP, VCC, HVH, GND) und zum Steuern für die Programmierung, das Löschen oder das Lesen (VPP, HVN, VREAD) zu übertragen,
einen ersten Transistor zum Auswählen einer Gruppe vom P-Typ (TSG1) unter den Zellengruppen, um über seinen Kanal die schwimmenden Gates der Speichertransistoren einer gleichen Zellengruppe mit einer der Steuerleitungen zu verbinden, wobei das Steuergate des ersten Auswahltransistors mit einer der ersten Auswahlleitungen bei der Programmierung, dem Löschen oder dem Lesen des Inhalts der Zellen der Zellengruppe verbunden wird, zu welcher der erste Auswahltransistor der Gruppe gehört.

2. Speicher nach Anspruch 1, dadurch gekennzeichnet, daß er N-Steuerleitungen derart umfaßt, daß alle Zellengruppen, die mit einer Wortleitung verbunden sind, ihre ersten Transistoren zum Auswählen der Gruppe mit einer Steuerleitung verbunden haben.

3. Speicher nach Anspruch 2, dadurch gekennzeichnet, daß der Speicher Vorrichtungen zum Umschalten (SW-CL, SW-SL1) umfaßt, um auf unterschiedliche Potentiale zum Auswählen und zum Steuern die ersten Leitungen zur Auswahl und zur Steuerung zu legen, derart, daß eine einzige Zellengruppe mit einer gleichen Wortleitung gleichzeitig zu der Steuerleitung, die mit dieser Wortleitung zusammenhängt, verbunden ist.

4. Speicher nach einem der Ansprüche 2 oder 3, dadurch gekennzeichnet, daß die Zellengruppen, deren Zellen mit K gleichen Bitleitungen verbunden sind, ihren ersten Transistor zum Auswählen mit einer gleichen ersten Auswahlleitung verbunden haben.

5. Speicher nach einem der Ansprüche 1 bis 4, dadurch gekennzeichnet, daß er umfaßt:
zweite Auswahlleitungen (SL2), die mit den Gruppenzellen und wenigstens einer Referenzleitung (LREF) zusammenhängen, um Potentiale zum Auswählen (VPP, VCC, HVH, GND) und als Referenz (VPP, HVN, VREAD) zu übertragen, und
einen zweiten Transistor zum Auswählen der Gruppe vom P-Typ (TSG2) pro Zellengruppe (CGR) zum Verbinden über seinen Kanal der schwimmenden Gates der Speichertransistoren (TGF1, ..., TGFK) einer gleichen Zellengruppe mit der Referenzleitung (LREF), wobei das Steuergate des zweiten Auswahltransistors (TSG2) mit einer von den zweiten Auswahlleitungen (SL2) derart verbunden ist, daß die Potentiale der Steuergates der Speichertransistoren der Zellen der dazugehörigen Gruppe sich in einem nichtschwimmenden Zustand befinden, wenn die Steuergates von der zu der Gruppe gehörenden Steuerleitung (CL) isoliert sind.

6. Speicher nach Anspruch 5, dadurch gekennzeichnet, daß die Zellengruppen, deren Zellen mit K gleichen Bitleitungen verbunden sind, ihren zweiten Auswahltransistor mit einer gleichen Referenzleitung verbunden haben.

7. Speicher nach Anspruch 6, dadurch gekennzeichnet, daß die Bitleitungen in Einheiten von K Leitungen zusammengefaßt sind, wobei diese Einheiten von K Leitungen paarweise gruppiert sind, und daß die Zellengruppen, deren Zellen mit einer von zwei Einheiten von K Bitleitungen zusammengefaßt sind, ihren zweiten Transistor für das Auswählen der Gruppe mit einer Referenzleitung verbunden haben.

8. Speicher nach einem der Ansprüche 5 bis 7, dadurch gekennzeichnet, daß die Zellengruppen, deren Zellen mit K Bitleitungen verbunden sind, ihren zweiten Transistor für das Auswählen der Gruppe mit einer gleichen zweiten Auswahlleitung (SL2) verbunden haben.

9. Speicher nach Anspruch 5, dadurch gekennzeichnet, daß die Zellengruppen, die mit einer gleichen Wortleitung (WL₁, WL₂) verbunden sind, ihren zweiten Transistor für das Auswählen der Gruppe mit einer gleichen Referenzleitung (LREF) verbunden haben.

10. Speicher nach Anspruch 9, dadurch gekennzeichnet, daß die Wortleitungen paarweise zusammengefaßt sind und daß die Zellengruppen, die mit der einen oder anderen der zwei Wortleitungen (WL₁, WL₂) zusammengefaßt sind, ihren zweiten Transistor für das Auswählen der Gruppe mit einer gleichen Referenzleitung (LREF) verbunden haben.

11. Speicher nach einem der Ansprüche 1 bis 10, dadurch gekennzeichnet, daß die Bitleitungen (BL1, ..., BLK) und die Auswahlleitungen (SL1, SL2) in einer ersten Metallisierungsschicht realisiert sind und daß die Steuerleitungen (CL) in einer zweiten Metallisierungsschicht realisiert sind.

12. Speicher nach einem der Ansprüche 5 bis 10, dadurch gekennzeichnet, daß die Bitleitungen (BL1, ..., BLK), die Auswahlleitungen (SL1, SL2) und die Referenzleitungen (LREF) in einer gleichen ersten Metallisierungsschicht realisiert sind und daß die Steuerleitungen (CL) in einer zweiten Metallisierungsschicht realisiert sind.

13. Speicher nach einem der Ansprüche 11 oder 12, dadurch gekennzeichnet, daß die Wortleitungen (WL) in der zweiten Metallisierungsschicht realisiert sind.

## Claims

1. EEPROM memory (1) which can be programmed and erased by Fowler-Nordheim effect, organised in a matrix in N word lines (WL) and M bit lines (BL), N and M being integer numbers, and comprising
memory cells placed at the intersections of the word lines (WL) and bit lines (BL), these memory cells comprising n-type floating gate storage transistors (TGF1, ..., TGFK) for storing electrical states, the memory cells being grouped together in groups (CGR) of K cells, with K an integer number, the cells in the same group being connected to the same word line and to K distinct bit lines,
first selection lines (SL1) and control lines (CL), associated with the groups of cells, for conveying selection potentials (VPP, VCC, HVH, GND) and control potentials for programming, erasing or reading (VPP, HVN, VREAD),
a first p-type group selection transistor (TSG1) per group of cells for connecting, via its channel, the floating gates of the storage transistors in one and the same group of cells to one of the control lines, the control gate of the first selection transistor being connected to one of the first selection lines, at the time of programming, erasing or reading of the content of the cells of the group of cells with which the first group selection transistor is associated.

2. Memory according to Claim 1, characterised in that it comprises N control lines so that all the groups of cells connected to one and the same word line have their first group selection transistors connected to the same control line.

3. Memory according to Claim 2, characterised in that the memory comprises switching means (SW-CL, SW-SL1) for raising the first selection and control lines to different selection and control potentials, so that a single group of cells connected to one and the same word line is connected simultaneously to the control line associated with this word line.

4. Memory according to one of Claims 2 to 3, characterised in that the group of cells whose cells are connected to K same bit lines have their first selection transistor connected to the same first selection line.

5. Memory according to one of Claims 1 to 4, characterised in that it comprises
second selection lines (SL2) associated with groups of cells and at least one reference line (LREF) for conveying selection potentials (VPP, VCC, HVH, GND) and reference potentials (VPP, HVN, VREAD), and
a second p-type group selection transistor (TSG2) per group of cells (CGR) for connecting, via its channel, the floating gates of the storage transistors (TGF1, ..., TGFK) of one and the same group of cells to the reference line (LREF), the control gate of the second selection transistor (TSG2) being connected to one of the second selection lines (SL2), so that the potentials of the control gates of the storage transistors of the cells in the associated group are in a non-floating state when these control gates are isolated from the control line (CL) associated with the group.

6. Memory according to Claim 5, characterised in that the groups of cells in which the cells are connected to K same bit lines have their second selection transistor connected to the same reference line.

7. Memory according to Claim 6, characterised in that the bit lines are grouped together in sets of K lines, these sets of K lines being grouped together in pairs, and in that the groups of cells in which the cells are connected to one of the two sets of K grouped-together bit lines have their second group selection transistor connected to the same reference line.

8. Memory according to one of Claims 5 to 7, characterised in that the groups of cells in which the cells are connected to K same bit lines have their second group selection transistor connected to the same second selection line (SL2).

9. Memory according to Claim 5, characterised in that the groups of cells connected to the same word line (WL₁, WL₂) have their second group selection transistor connected to the same reference line (LREF).

10. Memory according to Claim 9, characterised in that the word lines are grouped together in pairs, and in that the groups of cells connected to one or other of the two grouped-together word lines (WL₁, WL₂) have their second group selection transistor connected to the same reference line (LREF).

11. Memory according to one of Claims 1 to 10, characterised in that the bit lines (BL1, ..., BLK) and selection lines (SL1, SL2) are produced on one and the same first metallisation layer, and in that the control lines (CL) are produced on a second metallisation layer.

12. Memory according to one of Claims 5 to 10, characterised in that the bit lines (BL1, ..., BLK), the selection lines (SL1, SL2) and the reference lines (LREF) are produced on one on the same first metallisation layer, and in that the control lines (CL) are produced on a second metallisation layer.

13. Memory according to one of Claims 11 or 12, characterised in that the word lines (WL) are produced on the second metallisation layer.
